# EUROPÄISCHE PATENTSCHRIFT

(11) **EP 3 706 297 B1**
(45) Veröffentlichungstag und Bekanntmachung des Hinweises auf die Patenterteilung: **29.07.2026**
(21) Anmeldenummer: 19161181.3
(22) Anmeldetag: 07.03.2019
(51) Int. Cl.: B65G 43/00, H02K 11/26, H02K 16/00, H02K 41/02, B60L 13/03, H02P 25/064, B60L 13/00, B60L 15/00, H02P 6/16, H02K 11/27, H02K 11/21, B65G 54/02

(54) **VERFAHREN ZUM STEUERN EINES LANGSTATORLINEARMOTORS**
METHOD FOR CONTROLLING A LONG STATOR LINEAR MOTOR
PROCÉDÉ DE COMMANDE D'UN MOTEUR LINÉAIRE À STATOR LONG

(43) Veröffentlichungstag der Anmeldung: 09.09.2020
(73) Patentinhaber: ABB Schweiz AG, 5400 Baden (CH)
(72) Erfinder: Flixeder, Stefan, 5142 Eggelsberg (AT); Huber, Stefan, 5142 Eggelsberg (AT); Almeder, Alexander, 5142 Eggelsberg (AT)
(74) Vertreter: Weiss Patentanwalts GmbH

(56) Entgegenhaltungen:
- EP-A1- 3 251 986
- EP-A1- 3 367 068
- EP-A2- 2 860 496
- WO-A1-2008/072525
- JP-A- 2014 196 940
- US-A1- 2017 054 398
- US-A1- 2018 113 002
- BERNHARD HILLER: "Ferraris Acceleration Sensor - Principle and Field of Application in Servo Drives", 30 December 2003 (2003-12-30), XP055618711, Retrieved from the Internet <URL:https://pdfs.semanticscholar.org/ecfb/5b98a45473797e8e47f09f8f0c8a50f4bbd1.pdf?_ga=2.15626614.1718334140.1567668397-330839178.1567521626> [retrieved on 20190905]

## Beschreibung

Die gegenständliche Erfindung betrifft ein Verfahren zum Steuern eines Langstatorlinearmotors, wobei entlang einer Transportstrecke, welche aus mehreren Transportsegmenten mit jeweils einer Anzahl an Antriebsspulen zusammengesetzt ist, in einer Bewegungsrichtung in einem ersten Messabschnitt mittels eines oder mehrerer Messsensoren ein erster Messwert und in einem zweiten Messabschnitt ein zweiter Messwert mittels eines oder mehrerer Messsensoren ermittelt wird, wobei der erste Messwert und der zweite Messwert denselben Ist-Wert einer physikalischen Größe abbilden, von welchem eine Ist-Position einer Transporteinheit jeweils im ersten Messabschnitt und im zweiten Messabschnitt direkt oder indirekt abgebildet wird, und wobei die Messabschnitte an gegenüberliegenden Seiten der Transportstrecke vorgesehen sind und jeweils eines der Transportsegmente oder zumindest jeweils einen Teil eines der Transportsegmente abdecken.

Ein Langstatorlinearmotor (LLM) umfasst eine Vielzahl von nebeneinander angeordneten elektrischen Antriebsspulen, die ortsfest entlang einer Transportstrecke einseitig, zweiseitig oder mehrseitig angeordnet sind und einen oder mehrere Stator(en) bilden. Weiters ist jeweils auf Transporteinheiten eine Anzahl von Erregungsmagneten als Permanentmagnete oder als elektrische Spule bzw. als Kurzschlusswicklung angeordnet. Die Magnete sind üblicherweise derart in Bewegungsrichtung auf der Transporteinheit einseitig, zweiseitig oder mehrseitig angebracht, dass sie mit den Antriebsspulen des Stators zusammenwirken können. Der Langstatorlinearmotor kann als Synchronmaschine, sowohl selbsterregt oder fremderregt, oder als Asynchronmaschine ausgeführt sein. Durch das Zusammenwirken der (elektro-)magnetischen Felder der Magnete und der Antriebsspulen wirkt eine Vortriebskraft auf die Magnete der Transporteinheit, womit wiederum die Transporteinheit in Bewegungsrichtung bewegt wird. Dies erfolgt durch Ansteuerung der einzelnen Antriebsspulen zur Regelung des magnetischen Flusses, durch welchen die Größe der Vortriebskraft beeinflusst wird. Es werden vermehrt Langstatorlinearmotoren als Ersatz für konventionelle Stetigförderer bzw. rotativ-zu-linear Übersetzungseinheiten (z.B. rotativer Motor an Förderband, Riemen, Ketten etc.) eingesetzt, um den Anforderungen moderner, flexibler Logistikeinheiten gerecht zu werden. Eine Transporteinheit muss natürlich auf geeignete Weise entlang der Transportstrecke geführt und an dieser gehalten werden. Hierbei können an sich beliebige Führungselemente der Transporteinheiten mit Führungselementen der Transportstrecke zusammenwirken, wobei beispielsweise Rollen, Räder, Gleitelemente, Führungsflächen, usw. zum Einsatz kommen können. Auch diese Führungselemente können einseitig, zweiseitig oder mehrseitig angeordnet sein. Um die Positionen der Transporteinheiten am Stator zu regeln, ist neben einer Soll-Position natürlich auch eine Ist-Position erforderlich. Die Vorrichtung zur Erfassung der Ist-Position und zur Vorgabe der Ist-Position kann in den Langstatorlinearmotor integriert oder auch extern ausgeführt sein.

Es kann die Position, Geschwindigkeit, Beschleunigung der Transporteinheiten oder einer anderen physikalischen Größe der gesamten Transportstrecke gesamtheitlich ermittelt werden. Dies kann derart interpretiert werden, dass ein Messabschnitt vorgesehen ist, welcher die gesamte Transportstrecke abdeckt. Ein Messabschnitt umfasst einen oder mehrere Messsensoren zur Erfassung eines Messwerts. Der Messwert bildet jeweils einen Ist-Wert einer physikalischen Größe ab. Beispielsweise kann eine Position einer Transporteinheit im Messabschnitt als Messwert ermittelt werden, womit die Ist-Position als physikalische Größe abgebildet wird. Dies kann direkt durch Positionssensoren im Messabschnitt erfolgen. Es können auch Positionsbeobachter, welche die Position auf Basis anderer Informationen wie Spannungen und Strömen ermitteln, vorgesehen sein.

Ist somit nur ein Messabschnitt vorgesehen, so kann die Transportstrecke lediglich eine eindimensionale Topologie, d.h. einen Rundlauf oder eine Linie, aufweisen. Die Transportstrecke kann dann entsprechend keine Weichen umfassen, da sich der Messabschnitt ansonsten selbst überlappen müsste. Dem gegenüber kann die Transportstrecke eines Langstatorlinearmotors auch aus einer Mehrzahl Messabschnitte zusammengesetzt sein. Üblicherweise, jedoch nicht notwendigerweise, deckt ein Messabschnitt dabei jeweils ein Transportsegment oder einen Teil eines Transportsegments ab. Ein Transportsegment bezeichnet einen modularen Abschnitt der Transportstrecke und umfasst eine Anzahl von Antriebsspulen. Die Messabschnitte sind üblicherweise entlang der Transportstrecke in Bewegungsrichtung voneinander beabstandet oder aneinander angrenzend angeordnet.

Um eine globale Ist-Position einer Transporteinheit zu ermitteln, kann zuerst jeweils der Messabschnitt, an dem sich eine Transporteinheit befindet, ermittelt werden. Weiters kann eine Abschnitts-Ist-Position am jeweiligen Messabschnitt ermittelt werden. Die einzelnen Abschnitts-Ist-Positionen werden zu einer globalen Ist-Position an der Transportstrecke fusioniert. Damit kann der Transporteinheit eine eindeutige globale Ist-Position, z.B. in Bezug auf einen gewählten Referenzpunkt, zugeordnet werden. Überdecken die Messabschnitte zusammen die Transportstrecke des Linearmotors gänzlich, so kann den Transporteinheiten zu jedem Zeitpunkt eine eindeutige Ist-Position in Bezug auf einen (beliebigen) Referenzpunkt zugeordnet werden. Dies wird als komplementäre Sensordatenfusion bezeichnet und ist beispielsweise aus der US 6,876,107 B2 bekannt. Dabei ergänzen sich die einzelnen Messabschnitte und sind lückenlos aneinandergereiht.

Die EP 2 860 496 A2 und WO 2008/072525 A1 offenbaren jeweils Langstatorlinearmotoren, wobei gegenüberliegende Sensoren vorgesehen sind. Weiterhin ist aus der US 2018/113002 A1 ein Linearmotorsystem bekannt, bei welchem die Transportstrecke von Magneten gebildet wird, welche mit alternierender Polarität angeordnet sind. Aus der EP 3 251 986 A1 ist ein Verfahren zum Steuern eines Langstatorlinearmotors bekannt, wobei entlang einer Transportstrecke in einer Bewegungsrichtung in einem ersten Messabschnitt ein erster Messwert und in einem zweiten Messabschnitt ein zweiter Messwert ermittelt werden. Weiterhin ist aus Bernhard Hiller: "Ferraris Acceleration Sensor - Principle and Field of Application in Servo Drives", Hübner Elektromaschinen AG, Berlin, 30. 12. 2003 eine Anwendung von Ferraris Acceleration Sensoren in einem kleinen, eisenfreien und hoch dynamischen Lineardirektantrieb bekannt, wobei der Ferraris Acceleration Sensor mit einem optischen nicht gekapselten Linear-Impulsgeber zur Verbesserung der Positionsbestimmung kombiniert wird.

Es ist eine Aufgabe der gegenständlichen Erfindung, die Steuerung des Langstatorlinearmotors zu verbessern.

Diese Aufgabe wird erfindungsgemäß gelöst, indem der erste Messabschnitt in Bewegungsrichtung mit dem zweiten Messabschnitt in einem Überlappungsbereich überlappt, wobei im Überlappungsbereich die Transportstrecke zwei entlang der Transportstrecke angeordnete Antriebsseiten aufweist und jeweils ein Stator bzw. ein Transportsegment an jeder Antriebsseite der Transportstrecke angeordnet ist, und wobei anhand einer auftretenden Abweichung zwischen dem ersten Messwert dem zweiten Messwert ein Betriebsparameter des Langstatorlinearmotors bestimmt wird.

Durch eine Überlappung der Messabschnitte werden im Überlappungsbereich redundante Messwerte erzeugt. Der jeweilige Messwert kann im zugehörigen Messabschnitt durch einen Sensor, oder auch durch ein Zusammenspiel von Sensoren im jeweiligen Messabschnitt ermittelt, bzw. beobachtet werden. Es wird bestimmt, ob und wie stark der erste Messwert des ersten Messabschnitts vom zweiten Messwert des zweiten Messabschnitts abweicht, wobei natürlich eine Toleranz vorgesehen sein kann. Tritt eine Abweichung auf, so wird unter Verwendung derer ein Betriebsparameter bestimmt. Es kann der erste und/oder zweite Messwert zur Bestimmung des Betriebsparameters verwendet werden. Erster und zweiter Messwert selbst müssen lediglich die physikalische Größe abbilden. Das bedeutet nicht, dass die Messwerte direkt dieselbe physikalische Größe darstellen müssen. So kann beispielsweise der erste Messwert direkt eine Ist-Position beschreiben und der zweite Messwert einen Strom beschreiben, aus welchem wiederum die Ist-Position ermittelt wird. Somit bildet der erste Messwert die Ist-Position als physikalische Größe direkt ab und der zweite Messwert die Ist-Position als physikalische Größe indirekt ab.

Natürlich ist das erfindungsgemäße Verfahren nicht auf zwei Messwerte, die jeweils aus einem zugehörigen Messabschnitt stammen, beschränkt. Es kann auch je ein Messwert aus mehr als zwei überlappenden Messabschnitten zur Ermittlung des Betriebsparameters verwendet werden oder auch eine Mehrzahl an Messwerten aus zwei oder mehr überlappenden Messabschnitten.

Da die Messabschnitte an gegenüberliegenden Seiten der Transportstrecke vorgesehen sind, ergibt sich zwar in Bewegungsrichtung betrachtet ein Überlappungsbereich, die Messabschnitte können in einer zur Bewegungsrichtung quer liegenden Querrichtung durchaus voneinander beabstandet angeordnet sein. Derartige Anordnungen sind insbesondere bei Langstatorlinearmotoren mit Doppelkämmen anzutreffen. Doppelkamm-Langstatorlinearmotoren zeichnen sich durch zwei entlang der Transportstrecke angeordnete Antriebsseiten aus, wobei ein Stator pro Antriebsseite vorgesehen ist. An jeder Seite sind somit Antriebsspulen angeordnet. Demgemäß sind auch an einer Transporteinheit an beiden Seiten Erregungsmagnete vorgesehen, die jeweils mit den Antriebsspulen an einer Seite zusammenwirken.

Es kann die Konstellation vorgesehen sein, dass die Sensoren zweier Messabschnitte in Bewegungsrichtung überlappend angeordnet sind. Oftmals sind jedoch die den jeweiligen Messabschnitten zugehörigen Sensoren nicht überlappend angeordnet. Allerdings bezeichnen die Messabschnitte die Sichtweite der Sensoren und nicht die physikalische Ausdehnung der Sensoren selbst. Allgemein formuliert bedeuten überlappende Messabschnitte ein Überlappen der Sichtbereiche der Sensoren, wobei auch die Sensoren selbst überlappen können. Dies gilt natürlich auch für Messabschnitte, die an gegenüberliegenden Seiten der Transportstrecke angeordnet sind.

Natürlich können entlang einer Transportstrecke auch eine Mehrzahl Messabschnitte derart angeordnet sein, dass sich eine Mischung aus Überlappungsbereichen an gegenüberliegenden Seiten und an derselben Seite der Transportstrecke ergibt. Es kann auch ein dritter Messwert eines dritten Messabschnitts mit dem ersten und zweiten Messwert verglichen werden oder weitere Messwerte weiterer Messabschnitte, etc.

Vorteilhafterweise wird eine Näherung des Ist-Werts als Betriebsparameter bestimmt.

Diese Näherung kann natürlich über den gesamten Überlappungsbereich für auftretende Ist-Werte durchgeführt werden, wobei für die jeweiligen Ist-Werte jeweils ein erster und ein zweiter Messwert verwendet wird.

Es kann der erste oder der zweite Messwert als Näherung des Ist-Werts ausgewählt werden.

Dies entspricht einem selektiven Verfahren, was eine besonders rasche Näherung des Ist-Werts ermöglicht. So kann auch bei einem Ausfall eines Messabschnitts im Überlappungsbereich der andere Messabschnitt weiterhin Messwerte liefern, womit ein Ausfall des gesamten Langstatorlinearmotors verhindert wird.

Die Auswahl des ersten oder zweiten Messwerts kann auf Basis einer Klassifikation der jeweiligen Messwerts und/oder einer erwarteten Genauigkeit der jeweiligen Messwerte erfolgen.

Die Auswahl des ersten oder zweiten Messwerts als Näherung des Ist-Werts kann auf Basis einer vorliegenden Klassifikation des Messwerts bzw. des Messabschnitts erfolgen. So kann beispielsweise der Messwert, von dem aufgrund der Klassifikation angenommen werden kann, dass er genauer ist, ausgewählt werden.

Es kann auch eine Auswahl einer der Messwerte auf Basis der Genauigkeit der Messwerte getroffen werden. So kann beispielsweise angenommen werden, dass die Genauigkeit am Rand eines zugehörigen Messabschnitts absinkt, womit die Position des ermittelten Messwerts in Relation zum Messabschnitt in die Auswahl des Messwerts einfließen kann. Es kann bei der Auswahl auch eine Abnahme der Genauigkeit der Messwerte mit steigendem Abstand zwischen Sensor und Messobjekt als Geometriefaktor berücksichtigt werden. Bei gegenüberliegenden Messabschnitten können beispielsweise die Messwerte jenes Messabschnitts, an welchem sich eine Transporteinheit näher befindet ausgewählt werden.

Die Auswahl eines Messwerts kann auch unter Verwendung lernender Algorithmen, wie neuronale Netze, getroffen werden.

Wie erwähnt wird der Ist-Wert einer physikalischen Größe durch Messwerte in beiden Messabschnitten abgebildet. Da zwei Messwerte vorhanden sind, ist keine eindeutige Bestimmung des Ist-Werts möglich, weshalb die Messwerte vorzugsweise verarbeitet werden um den Ist-Wert anzunähern. Damit kann der Ist-Wert mit einer erhöhten Genauigkeit bestimmt werden, da nicht nur ein Messwert eines Messabschnitts, sondern Messwerte aus zwei (oder mehr) Messabschnitten als Basis dienen. Dies wird als konkurrierende Sensordatenfusion bezeichnet. Der zu wählende Ist-Wert kann auf Basis einer vorliegenden Klassifikation des Messwerts bzw. des Messabschnitts bestimmt werden. Der Ist-Wert kann beispielsweise auch über eine Mittelung der Messwerte angenähert werden.

Vorteilhafterweise werden jedoch der erste und zweite Messwert jeweils mit einem Gewichtungsfaktor versehen und aus dem ersten und zweiten Messwert und dem jeweils zugehörigen Gewichtungsfaktor die Näherung des Ist-Werts als Betriebsparameter ermittelt.

Im Gegensatz zu einem selektiven Verfahren, wird nicht ein Messwert als Näherung des Ist-Werts ausgewählt. Vielmehr werden beide Messwerte berücksichtigt, wobei beide Messwerte jeweils gewichtet werden. Durch die Verwendung eines Gewichtungsfaktors für die jeweiligen Messwerte kann der Ist-Wert noch besser angenähert werden.

Der Gewichtungsfaktor kann auch einen Modellfaktor umfassen, welcher durch die Höhe einer Abweichung des Messwerts von einem Referenzmodell bestimmt wird.

Der Modellfaktor kann somit auf Basis eines Referenzmodells bestimmt werden, wobei durch das Modell beispielsweise ein physikalisches Verhalten abgebildet werden kann. So können z.B. die Bewegungsgleichungen einer Transporteinheit für die Modellbildung verwendet werden und die Abweichung der durch die Messwerte bestimmten tatsächlichen Bewegung in den Modellfaktor einfließen. Je größer die Abweichung zwischen einem Messwert und dem Modell ist, desto wahrscheinlicher ist dieser Messwert nicht korrekt. Darauf basierend kann der Modellfaktor gewählt werden. Dies kann insbesondere bei gegenüberliegenden Messabschnitten auftreten, da diese zwar in Bewegungsrichtung überlappen, jedoch dennoch in Querrichtung voneinander beabstandet sein können, was mit einer hohen Wahrscheinlichkeit unterschiedliche Messwerte liefern kann.

Der Gewichtungsfaktor kann einen Geometriefaktor umfassen, welcher durch die Position des Messwerts im Messabschnitt bestimmt wird.

Beispielsweise kann angenommen werden, dass die Genauigkeit der Messwerte am Rand eines zugehörigen Messabschnitts absinkt, womit die Position des ermittelten Messwerts in Relation zum Messabschnitt in den Geometriefaktor einfließen kann. Messwerte am Rand des Messabschnitts werden somit beispielsweise geringer gewichtet als Messwerte im Zentrum des Messabschnitts. Es kann auch eine Abnahme der Genauigkeit der Messwerte mit steigendem Abstand zwischen Sensor und Messobjekt als Geometriefaktor berücksichtigt werden. Bei gegenüberliegenden Messabschnitten können beispielsweise die Messwerte jenes Messabschnitts, an welchem sich eine Transporteinheit näher befindet, höher gewichtet werden.

Der Gewichtungsfaktor kann einen Statistikfaktor umfassen, welcher durch eine statistische Verteilungsfunktion bestimmt wird.

Der Statistikfaktor kann beispielsweise parametrierte Zufallsverteilung der Messsignale berücksichtigen, wobei die Varianz der Messwerte geschätzt werden kann. Dies kann insbesondere bei einer Bestimmung der Ist-Position erfolgen, indem angenommen wird, dass mit steigendem Abstand zwischen Magnetplatte der Transporteinheit und Positionssensor die Varianz ansteigt. Dies ist besonders zielführend in Kombination mit einem geometrischen Gewichtungsfaktor.

Weiters können die Gewichtungsfaktoren auch durch lernende Algorithmen, wie neuronale Netze, verwendet werden. Selbstverständlich kann für die Bestimmung der Gewichtungsfunktionen eine beliebige Kombination der genannten Faktoren und Methoden herangezogen werden.

Es kann jeweils eine Mess-Position einer Transporteinheit an der Transportstrecke als erster und zweiter Messwert ermittelt werden.

Damit kann die Ist-Position als Ist-Wert jeweils durch die Mess-Positionen als Messwerte abgebildet werden und somit die Steuerung der Transporteinheiten verbessert werden, da durch die Berücksichtigung der Messwerte mehrerer Messabschnitte die Ist-Position genauer bestimmt werden kann.

Ebenso kann jeweils eine Geschwindigkeit und/oder eine Beschleunigung einer Transporteinheit an der Transportstrecke und/oder jeweils eine Temperatur und/oder ein Strom als erster und zweiter Messwert ermittelt werden.

Es kann aus der Abweichung des ersten und zweiten Messwerts das Auftreten einer Störung und/oder eines Fehlers und/oder eines Verschleißes am Langstatorlinearmotors als Betriebsparameter bestimmt werden.

Tritt eine Störung, ein Fehler oder Verschleiß auf, so können erster Messwert und zweiter Messwert über eine vorgegebene Toleranz voneinander abweichen. Damit kann über eine entsprechende Abweichung auf eine Störung, einen Fehler oder einen Verschleiß rückgeschlossen werden.

Die Messwerte können sicher erfasst und/oder sicher ausgewertet werden. "Sicher" kann nach einer Kategorie der Tabelle 10 der Norm DIN EN ISO 13849-1:2016-06 festgelegt werden und somit je nach Sicherheitskategorie eine Einfehlersicherheit, eine Zweifehlersicherheit, etc. vorgesehen sein.

Bei der Detektion einer Störung, eines Fehlers oder Verschleißes kann eine Aktion ausgelöst werden. Als Aktion kann ein Not-Stopp, die Ausgabe eines (z.B. akustischen oder optischen) Signals, das Setzen eines Flags, etc. durchgeführt werden.

Als Fehler können mechanische Montagefehler, aber auch Ausfälle (z.B. eines Messabschnitts aufgrund eines Sensorfehlers oder eines Magnetplattenverlusts, etc.) angesehen werden. Es können ebenso fehlerhaft initialisierte Parameter, z.B. eine fehlerhafte Festlegung eines Messabschnitts, ermittelt werden, womit sich der Messwert dieses Messabschnitts vom Messwert eines überlappenden Messabschnitts entsprechend unterscheidet.

Eine Fehlmontage von Transportsegmenten kann zu einer Fehlpositionierung einer Transporteinheit an der Transportstrecke führen, womit übergeordnete Prozesse, insbesondere die Regelung der Positionen bzw. Trajektorien der Transporteinheiten, gestört werden können. So können sich unstetige Stellgrößen, instabile Regelkreise, Überstromfehler, Schleppfehlerabbrüche, etc. ergeben. Es kann auch der Fall eintreten, dass Regelkreise sich zum Teil gegeneinander ausregeln, womit wiederum instabile Regelkreise erzeugt werden können und zudem ein erhöhter Energiebedarf entstehen kann. Es kann durch eine Abweichung der Messwerte im Überlappungsbereich auf eine derartige fehlerhafte Montage von Transportsegmenten geschlossen werden, insbesondere wenn die Messabschnitte jeweils Transportsegmente abdecken.

Analog können auch Störungen, wie Umweltbedingungen (z.B.: erhöhte Temperatur) erkannt werden, da diese die Messwerte der Sensoren einzelner Messabschnitte beeinflussen. Weiters kann der Ausfall eines Messabschnitts oder eines Teils eines Messabschnitts (Sensorausfall, Magnetplattenverlust, ...), erkannt werden.

Durch eine Abweichung der Messwerte kann auch beispielsweise ein Verschleiß von Führungselementen, wie z.B. Rollen, erkannt werden, insbesondere bei gegenüberliegend positionierten Messabschnitten. So kann aufgrund unterschiedlicher Messwerte eine Veränderung des Abstands der beweglichen Teile zum jeweiligen Messabschnitt erkannt werden. Dies lässt bei abweichenden Messwerten überlappender Messabschnitte einen Schluss auf eine einseitige Abnützung der Führungselemente (z.B. Rollen), Magnetplattenverlust, eine Entmagnetisierung einer Magnetplatte, einer Sensorfehlfunktion (z.B. Sensordrift, ...), zu.

Es kann ebenso ermittelt werden, auf welcher Seite die Transporteinheit einen geringeren Abstand zur Transportstrecke aufweist. Dies kann beispielsweise ebenso durch einen einseitigen Verschließ auftreten. Diese Information kann für eine gezielte Aktuierung der Antriebsspulen auf der Seite mit geringerem Abstand verwendet werden, womit Energie gespart werden kann und zudem auftretende Verluste verringert werden können.

Die gegenständliche Erfindung wird nachfolgend unter Bezugnahme auf die Figuren 1 bis 2b näher erläutert, die beispielhaft, schematisch und nicht einschränkend vorteilhafte Ausgestaltungen der Erfindung zeigen. Dabei zeigt
- Fig.1: einen Langstatorlinearmotor,
- Fig.2a: zwei Messabschnitte auf derselben Seite der Transportstrecke,
- Fig.2b: zwei Messabschnitte auf gegenüberliegenden Seiten der Transportstrecke.

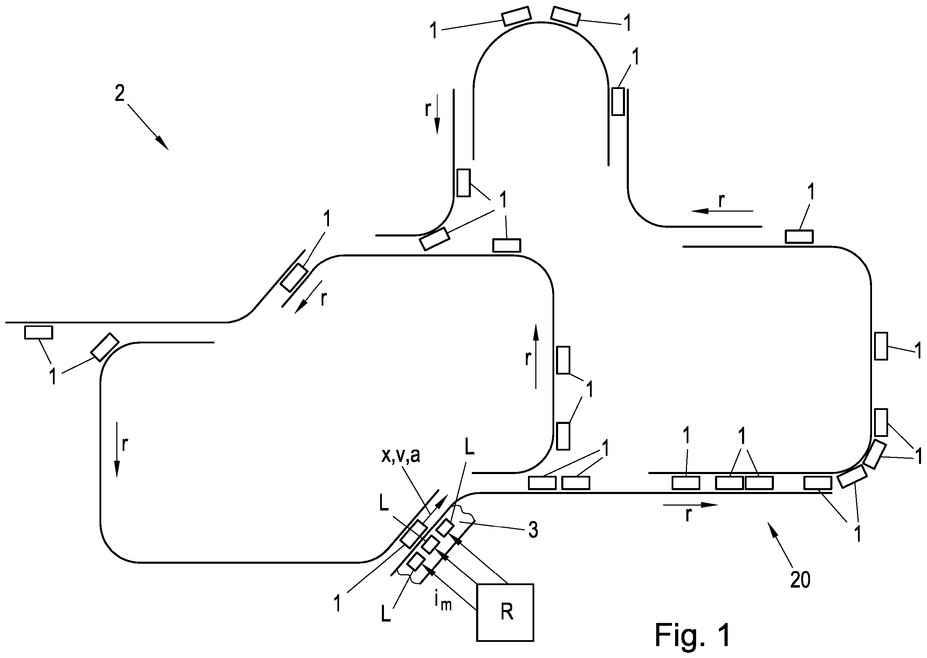

Fig.1 stellt einen Langstatorlinearmotor 2 dar, wobei der Stator des Langstatorlinearmotors 2 beispielhaft als geschlossene Transportstrecke 20 ausgeführt ist. Auf der Transportstrecke 20 sind eine Vielzahl von Antriebsspulen L in Bewegungsrichtung r einer Transporteinheit 1 hintereinander angeordnet, die im Normalbetrieb unter Kontrolle einer Steuereinheit R jeweils mit einem Spulenstrom iₘ bestromt werden, um ein bewegtes Magnetfeld zu erzeugen. Der Spulenstrom iₘ durch die jeweiligen Antriebsspulen L kann grundlegend von Antriebsspule L zu Antriebsspule L verschieden sein. Die Steuereinheit R kann als geeignete Hardware und/oder als auf einer geeigneten Hardware laufende Software ausgeführt sein. Die in Bewegungsrichtung r nebeneinander angeordneten Antriebsspulen L sind an einer ortsfesten Haltekonstruktion 3 (in den Figuren nur angedeutet) an der Transportstrecke 20 angeordnet. Die Transportstrecke 20 kann dabei, je nach Anwendung und Bedarf, beliebig geformt sein und kann geschlossene und/oder offene Streckenabschnitte umfassen. Die Transportstrecke 20 kann in einer Ebene liegen, aber auch beliebig im Raum geführt sein.

Üblicherweise besteht eine Transportstrecke 20 aus mehreren zusammengesetzten Transportsegmenten mit jeweils einer Anzahl von Antriebsspulen L. Gleichfalls können auch Weichen verwendet werden um eine Transporteinheit 1 von einem ersten Transportsegment 20 auf ein zweites Transportsegment zu führen.

Eine Transporteinheit 1 muss natürlich auf geeignete Weise entlang der Transportstrecke 20 geführt und an dieser gehalten werden. Hierbei können an sich beliebige Führungselemente der Transporteinheit 1 mit Führungselementen der Transportstrecke 20 zusammenwirken, wobei beispielsweise Rollen, Räder, Gleitelemente, Führungsflächen, usw. zum Einsatz kommen können. Auch diese Führungselemente können abschnittsweise einseitig, zweiseitig oder mehrseitig angeordnet sein.

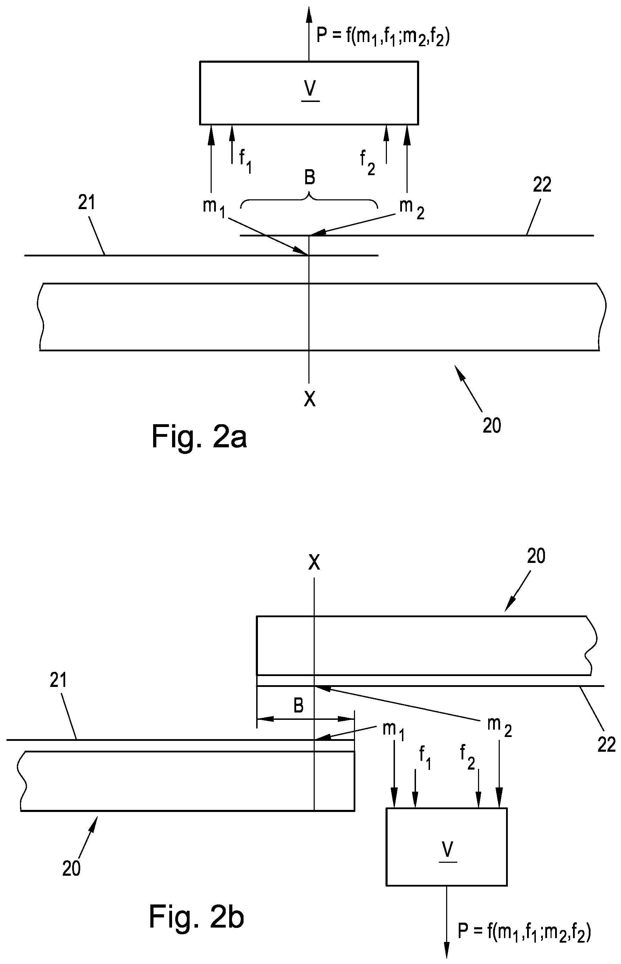

Es sind entlang der Transportstrecke 20 des Langstatorlinearmotors 2 Messabschnitte 21, 22 angeordnet, wobei sich ein Messabschnitt 21, 22 jeweils über einen Teil der Transportstrecke 20 erstreckt. Ein Messabschnitt 21, 22 kann sich dabei über mehrere aufeinanderfolgende Transportsegmente erstrecken, oder auch nur auf ein Transportsegment beschränken. Natürlich kann ein Messabschnitt 21, 22 auch über ein Transportsegment hinausragen oder unabhängig von Transportsegmenten betrachtet werden. Aus diesem Grund werden in der gegenständlichen Beschreibung Messabschnitte 21,22 und keine Transportsegmente betrachtet. Aus Übersichtlichkeitsgründen sind die Messabschnitte 21,22 in Fig. 1 nicht eingezeichnet. Vielmehr wird ein Teil der Transportstrecke 20 in den Fig. 2a und 2b betrachtet, wobei jeweils überlappende Messabschnitte 21,22 dargestellt sind.

Ein Messabschnitt 21, 22 ist dazu ausgestaltet einen oder mehrere Messwerte m1, m2 zu ermitteln, wobei ein Messwert m1, m2 jeweils einen Ist-Wert X einer physikalischen Größe G abbildet. Als physikalische Größe G kann eine Ist-Position x und/oder eine Ist-Geschwindigkeit v und/oder eine Ist-Beschleunigung a einer Transporteinheit 1 angesehen werden. Damit stellt ein Messwert m1, m2 jeweils ein Mess-Position, eine Mess-Geschwindigkeit, bzw. eine Mess-Beschleunigung dar und bildet damit eine Ist-Position x, eine Ist-Geschwindigkeit v, bzw. eine Ist-Beschleunigung a ab, wobei nicht beide Messwerte m1, m2 dieselbe physikalische Größe G direkt darstellen müssen, sondern diese lediglich abbilden.

Wird eine Ist-Position als physikalische Größe G ermittelt, so kann dies in Bezug auf einen Referenzpunkt erfolgen, wobei der Referenzpunkt an einem Messabschnitt 21, 22, einem Transportsegment oder einen beliebigen anderen Punkt im Raum angenommen werden kann. Es können auch andere physikalische Größen G, wie eine vorherrschende Kraft, ein fließender Strom, eine vorherrschende Temperatur, etc., durch die Messwerte m1, m2 abgebildet werden. Daraus kann wiederum eine physikalische Größe G wie eine Ist-Position x errechnet werden, was auch über einen Beobachter erfolgen kann.

Es kann auch ein erster Messwert m1 eine physikalische Größe G, z.B. die Ist-Position, direkt abbilden. Das bedeutet, dass der erste Messwert m1 die Ist-Position selbst darstellt. Ein zweiter Messwert m2 hingegen kann eine andere physikalische Größe, z.B. einen elektrischen Strom darstellen, aus welchem die Ist-Position als physikalische Größe G abgebildet wird. Damit beschreibt der erste Messwert m1 die physikalische Größe G direkt und der zweite Messwert m2 die physikalische Größe G indirekt. Beide Messwerte m1, m2 bilden jedoch die physikalische Größe G ab.

Als Sensoren können somit Magnetfeldsensoren, z.B. Hall-Sensoren, magnetoresistive Sensoren, vorgesehen sein. Die Sensoren können aber auch andere physikalische Messprinzipien nutzen, wie beispielsweise optische Sensoren, kapazitive Sensoren, induktive Sensoren, etc. Es können auch Stromsensoren, welche den Spulenstrom iₘ durch eine Antriebsspule L bestimmten, vorgesehen sein. Aus dem Spulenstrom iₘ kann bekanntermaßen beispielsweise eine auf eine Transporteinheit 1 wirkende Normalkraft und/oder Vortriebskraft bestimmt werden. Auch ein Temperatursensor kann als Sensor vorgesehen sein.

Es ist in Fig. 2a beispielhaft ein erster und ein zweiter Messabschnitt 21,22 dargestellt. Erfindungsgemäß weisen zumindest zwei Messabschnitte 21, 22 in Bewegungsrichtung r, d.h. entlang der Transportstrecke 20 einen Überlappungsbereich B auf. Die in einem Überlappungsbereich B überlappenden Messabschnitte 21, 22 können wie in Fig. 2a an derselben Seite der Transportstrecke 20, oder auch auf gegenüberliegenden Seiten der Transportstrecke 20 angeordnet sein, wie in Fig. 2b dargestellt.

Es wird in beiden dargestellten Fällen im Überlappungsbereich B im ersten Messabschnitt 21 ein erster Messwert m1 und im Überlappungsbereich B im zweiten Messabschnitt 22 ein zweiter Messwert m2 ermittelt. Beide Messwerte m1, m2 bilden dabei denselben Ist-Wert X einer physikalischen Größe G ab. So kann beispielsweise eine Ist-Position x einer Transporteinheit 1 als Ist-Wert X durch den ersten Messwert m1 des ersten Messabschnitts 21 abgebildet werden. Analog kann die Ist-Position x der Transporteinheit 1 als Ist-Wert X ebenso durch den zweiten Messwert m2 des zweiten Messabschnitts 22, d.h. als zweite Mess-Ist-Position, abgebildet werden.

Es ist in den Fig. 2a, b nur ein Ist-Wert X dargestellt, natürlich können im Überlappungsbereich B auch andere und/oder weitere Ist-Werte X ermittelt werden, wobei jeweils Messwerte m1, m2, die die anderen/weitern Ist-Werte X abbilden, ermittelt werden.

Unterscheiden sich der erste Messwert m1 und der zweite Messwert m2, so kann aus der Abweichung des ersten Messwerts m1 vom zweiten Messwert m2 ein Betriebsparameter P des Langstatorlinearmotors 2 bestimmt werden, womit der Betriebsparameter P sich als Funktion der Messwerte ergibt P=f(m1, m2).

Dies erfolgt in den Fig.2a, 2b beispielhaft in einer Verarbeitungseinheit V, kann stattdessen natürlich z.B. auch in der Steuereinheit R oder einer weiteren bereits am Langstatorlinearmotor 1 vorhandenen Einheit erfolgen. Der Betriebsparameter P kann weiters ausgegeben und/oder verarbeitet werden, beispielsweise zur Steuerung der Transporteinheiten 1.

Es kann aus der Abweichung des ersten und zweiten Messwerts m1, m2 als Betriebsparameter P beispielsweise eine Näherung des tatsächlichen Ist-Werts X bestimmt werden. Dies kann erfolgen, indem die Messabschnitte 21, 22 in ein gemeinsames Koordinatensystem transformiert werden. Die Messwerte m1, m2 können gemittelt oder auch jeweils mit einem Gewichtungsfaktor f1, f2 versehen werden, womit sich der Betriebsparameter P als Funktion der Messwerte m1, m2 und dem jeweils zugehörigen Gewichtungsfaktor f1, f2 ergibt: P=f(m1,f2 ; m2,f2). Als Betriebsparameter P kann eine Näherung des Ist-Werts X ermittelt werden. Ein Gewichtungsfaktor f1, f2 eines Messabschnitts 21, 22 kann initial festgelegt sein und/oder über die Zeit angepasst werden.

Der jeweilige Messabschnitt 21, 22 kann dabei auch Bereiche unterschiedlicher Messgenauigkeit enthalten, wobei sich die Mess-Genauigkeit über einen Messabschnitt 21, 22 oder einen Teil des Messabschnitts 21, 22 diskret und/oder kontinuierlich ändern kann. Ebenso kann sich die Mess-Genauigkeit eines Messabschnitts 21, 22 zeitlich und/oder in Abhängigkeit von anderen Einflüssen, wie Temperatur, Verschmutzung und/oder Alterung der Sensoren, etc., ändern. So kann der jeweilige Gewichtungsfaktor f1, f2 einen Geometriefaktor umfassen, welcher durch die Position des Messwerts m1, m2 im Messabschnitt 21, 22 bestimmt wird. Es kann, z.B. eine Genauigkeit abhängig von der Position am Messabschnitt 21,22, der Abstand zum Messobjekt, die Temperatur, magnetische Streufelder, etc., in den Geometriefaktor einfließen. Sinkt die Genauigkeit der Messwerte m1, m2 zum Rand des Messabschnitts 21, 22 ab, so kann der Geometriefaktor als Funktion des Abstands zum Mittelpunkt des Messabschnitts 21, 22 verwendet werden.

Selbstverständlich kann ein Gewichtungsfaktor f1, f2 abhängig von der Position des Messwerts in Relation zum Messabschnitt 21, 22 variieren, was ebenso durch einen Geometriefaktor erreicht werden kann.

Der Gewichtungsfaktor f1, f2 kann auch einen Statistikfaktor umfassen, welcher durch eine statistische Verteilungsfunktion bestimmt wird. Sind die Wahrscheinlichkeitsverteilungen der einzelnen Messabschnitte 21, 22 bekannt, voneinander unabhängig, normalverteilt und haben denselben Mittelwert, so kann ein Maximum-Likelihood-Schätzer, welcher gewichtete kleinste Quadrate verwendet, verwendet werden. Dabei kann die Varianz auf einem Messabschnitt 21, 22 sowohl eine Funktion der Zeit, als auch der Position auf dem Messabschnitt 21, 22 sein.

Ebenso können Modellfaktoren in die Gewichtungsfaktoren f1, f2 einfließen. Als Beispiel für einen modellbasierten Schätzer sei das Kalman-Filter genannt. Es können auch beim Design eines Kalman-Filter Annahmen über die Wahrscheinlichkeitsverteilung der Messwerte m1, m2 gemacht werden.

Es könnte auch der erste oder der zweite Messwert m1, m2 selbst oder ein Mittelwert des ersten oder des zweiten Messwerts m1, m2 als Näherung des Ist-Werts X ausgewählt werden. Es können die oben im Rahmen der Gewichtungsfaktoren genannten Informationen, welche in die Statistikfaktoren und/oder Geometriefaktoren einfließen, gleichermaßen für die Auswahl eines Messwerts m1, m2 als Näherung des Ist-Werts X verwendet werden.

Es kann aus der Abweichung des ersten und zweiten Messwerts m1, m2 das Auftreten einer Störung und/oder eines Fehlers und/oder eines Verschleißes am Langstatorlinearmotors 2 als Betriebsparameter P bestimmt werden. Dies ist möglich, wenn die Messwerte m1, m2 überlappender Messabschnitte 21,22 aufgrund der Störung, bzw. des Fehlers, bzw. des Verschleißes voneinander abweichen. In einem Umkehrschluss kann somit auf die Störung, bzw. den Fehler, bzw. den Verschleiß geschlossen werden. Dabei kann beispielsweise auf Basis der Höhe der Abweichung auf die Art der Störung, des Fehlers, oder den Verschleiß geschlossen werden. Als Störungen können auch geänderte Umweltbedingungen, wie beispielsweise eine erhöhte Temperatur, angesehen werden.

## Patentansprüche

1. Verfahren zum Steuern eines Langstatorlinearmotors (2), wobei entlang einer Transportstrecke (20), welche aus mehreren Transportsegmenten mit jeweils einer Anzahl an Antriebsspulen (L) zusammengesetzt ist, in einer Bewegungsrichtung (r) in einem ersten Messabschnitt (21) mittels eines oder mehrerer Messsensoren ein erster Messwert (m1) und in einem zweiten Messabschnitt (22) mittels eines oder mehrerer Messsensoren ein zweiter Messwert (m2) ermittelt wird, wobei der erste Messwert (m1) und der zweite Messwert (m2) denselben Ist-Wert (X) einer physikalischen Größe (G) abbilden, von welchem eine Ist-Position einer Transporteinheit (1) jeweils im ersten Messabschnitt (21) und im zweiten Messabschnitt (22) direkt oder indirekt abgebildet wird, und wobei die Messabschnitte (21, 22) an gegenüberliegenden Seiten der Transportstrecke (20) vorgesehen sind und jeweils eines der Transportsegmente oder zumindest jeweils einen Teil eines der Transportsegmente abdecken, wobei der erste Messabschnitt (21) in Bewegungsrichtung (r) mit dem zweiten Messabschnitt (22) in einem Überlappungsbereich (B) überlappt, wobei im Überlappungsbereich (B) die Transportstrecke (20) zwei entlang der Transportstrecke (20) angeordnete Antriebsseiten aufweist und jeweils ein Stator bzw. ein Transportsegment an jeder Antriebsseite der Transportstrecke (20) angeordnet ist, **und dass** anhand einer auftretenden Abweichung zwischen dem ersten Messwert (m1) und dem zweiten Messwert (m2) ein Betriebsparameter (P) des Langstatorlinearmotors (2) bestimmt wird.

2. Verfahren nach Anspruch 1, **dadurch gekennzeichnet, dass** eine Näherung des Ist-Werts (X) als Betriebsparameter (P) bestimmt wird.

3. Verfahren nach Anspruch 2, **dadurch gekennzeichnet, dass** der erste oder der zweite Messwert (m1, m2) als Näherung des Ist-Werts (X) ausgewählt wird.

4. Verfahren nach Anspruch 2, **dadurch gekennzeichnet, dass** die Auswahl des ersten oder zweiten Messwerts (m1, m2) auf Basis einer Klassifikation der jeweiligen Messwerte erfolgt.

5. Verfahren nach Anspruch 3 oder 4, **dadurch gekennzeichnet, dass** die Auswahl des ersten oder zweiten Messwerts (m1, m2) auf Basis einer erwarteten Genauigkeit der jeweiligen Messwerte erfolgt.

6. Verfahren nach Anspruch 2, **dadurch gekennzeichnet, dass** der erste und zweite Messwert (m1, m2) jeweils mit einem Gewichtungsfaktor (f1, f2) versehen wird, **und dass** aus dem ersten und zweiten Messwert (m1, m2) und dem jeweils zugehörigen Gewichtungsfaktor (f2, f2) die Näherung des Ist-Werts (X) als Betriebsparameter (P) ermittelt wird.

7. Verfahren nach Anspruch 6, **dadurch gekennzeichnet, dass** der Gewichtungsfaktor (f1, f2) einen Modellfaktor umfasst, welcher durch die Höhe einer Abweichung des zugehörigen Messwerts (m1, m2) von einem Referenzmodell bestimmt wird.

8. Verfahren nach einem der Ansprüche 6 oder 7, **dadurch gekennzeichnet, dass** der Gewichtungsfaktor (f1, f2) einen Geometriefaktor umfasst, welcher durch die Position des jeweiligen Messwerts (m1, m2) im zugehörigen Messabschnitt (21, 22) bestimmt wird.

9. Verfahren nach einem der Ansprüche 6 bis 8, **dadurch gekennzeichnet, dass** der Gewichtungsfaktor (f1, f2) einen Statistikfaktor umfasst, welcher durch eine statistische Verteilungsfunktion bestimmt wird.

10. Verfahren nach einem der Ansprüche 1 bis 9, **dadurch gekennzeichnet, dass** das Auftreten einer Störung und/oder eines Fehlers und/oder eines Verschleißes am Langstatorlinearmotors (2) als Betriebsparameter (P) bestimmt wird.

11. Verfahren nach einem der Ansprüche 1 bis 10, **dadurch gekennzeichnet, dass** jeweils eine Position einer Transporteinheit (1) an der Transportstrecke (20) als erster und zweiter Messwert (m1, m2) ermittelt wird.

12. Verfahren nach einem der Ansprüche 1 bis 10, **dadurch gekennzeichnet, dass** jeweils eine Geschwindigkeit und/oder eine Beschleunigung einer Transporteinheit (1) an der Transportstrecke (20) als erster und zweiter Messwert (m1, m2) ermittelt wird.

13. Verfahren nach einem der Ansprüche 1 bis 10, **dadurch gekennzeichnet, dass** jeweils eine Temperatur und/oder ein Strom, als erster und zweiter Messwert (m1, m2) ermittelt wird.

## Claims

1. Method for controlling a long-stator linear motor (2), wherein, along a transport path (20) composed of a plurality of transport segments, each having a number of drive coils (L), a first measured value (m1) is determined in a first measurement section (21) by one or more measurement sensors, and a second measured value (m2) is determined in a second measurement section (22) by one or more measurement sensors, wherein the first measured value (m1) and the second measured value (m2) represent the same actual value (X) of a physical quantity (G), from which an actual position of a transport unit (1) is respresented directly or indirectly in the first measurement section (21) and in the second measurement section (22), and wherein the measurement sections (21, 22) are provided on opposite sides of the transport path (20) and each cover on of the transport segments or at least a portion of one of the transport segments, wherein the first measurement section (21) overlaps, in an overlap region (B) in the movement direction (r), the second measurement section (22), wherein the transport path (20) has two drive sides arranged along the transport path (20) in the overlap region (B), and a stator or a transport segment is arranged on each drive side of the transport path, and wherein an operating parameter (P) of the long-stator linear motor (2) is determined based on a deviation occurring between the first measured value (m1) and the second measured value (m2).

2. Method according to claim 1, **characterized in that** an approximation of the actual value (X) is determined as the operating parameter (P).

3. Method according to claim 2, **characterized in that** the first or the second measured value (m1, m2) is selected as an approximation of the actual value (X).

4. Method according to claim 2, **characterized in that** the first or the second measured value (m1, m2) is selected based on a classification of the respective measured values.

5. Method according to either claim 3 or 4, **characterized in that** the first or the second measured value (m1, m2) is selected based on an expected accuracy of the respective measured values.

6. Method according to claim 2, **characterized in that** each of the first and the second measured value (m1, m2) is provided with a weighting factor (f1, f2), **and in that** the approximation of the actual value (X) is ascertained as the operating parameter (P) from the first and the second measured value (m1, m2) and from the associated weighting factor (f2, f2) in each case.

7. Method according to claim 6, **characterized in that** the weighting factor (f1, f2) comprises a model factor which is determined by the magnitude of a deviation of the associated measured value (m1, m2) from a reference model.

8. Method according to either claim 6 or 7, **characterized in that** the weighting factor (f1, f2) comprises a geometry factor which is determined by the position of the relevant measured value (m1, m2) in the associated measurement section (21, 22).

9. Method according to any of claims 6 to 8, **characterized in that** the weighting factor (f1, f2) comprises a statistical factor which is determined by a statistical distribution function.

10. Method according to any of claims 1 to 9, **characterized in that** the occurrence of interference and/or an error and/or wear on the long-stator linear motor (2) is determined as the operating parameter (P).

11. Method according to any of claims 1 to 10, **characterized in that** in each case a position of a transport unit (1) on the transport path (20) is ascertained as the first and the second measured value (m1, m2).

12. Method according to any of claims 1 to 10, **characterized in that** in each case a speed and/or an acceleration of a transport unit (1) on the transport path (20) is ascertained as the first and the second measured value (m1, m2).

13. Method according to any of claims 1 to 10, **characterized in that** in each case a temperature and/or a current is ascertained as the first and the second measured value (m1, m2).

## Revendications

1. Procédé de commande d'un moteur linéaire à stator long (2), dans lequel, le long d'une section de transport (20) composée de plusieurs segments de transport comportant chacun un nombre de bobines d'entraînement (L), sont déterminées, dans un sens de déplacement (r), une première valeur de mesure (m1) dans une première section de mesure (21) au moyen d'un ou de plusieurs capteurs de mesure et une deuxième valeur de mesure (m2) dans une deuxième section de mesure (22) au moyen d'un ou de plusieurs capteurs de mesure, la première valeur de mesure (m1) et la deuxième valeur de mesure (m2) représentant la même valeur réelle (X) d'une grandeur physique (G), à partir de laquelle une position réelle d'une unité de transport (1) est représentée directement ou indirectement respectivement dans la première section de mesure (21) et dans la deuxième section de mesure (22), et les sections de mesure (21, 22) étant prévues sur des côtés opposés de la section de transport (20) et recouvrant respectivement l'un des segments de transport ou au moins respectivement une partie de l'un des segments de transport, la première section de mesure (21) chevauchant la deuxième section de mesure (22) dans une zone de chevauchement (B) dans le sens de déplacement (r), la section de transport (20) présentant, dans la zone de chevauchement (B), deux côtés d'entraînement disposés le long de la section de transport (20) et un stator ou respectivement un segment de transport étant disposé sur chaque côté d'entraînement de la section de transport (20), et un paramètre de fonctionnement (P) du moteur linéaire à stator long (2) étant déterminé sur la base d'un écart apparaissant entre la première valeur de mesure (m1) et la deuxième valeur de mesure (m2).

2. Procédé selon la revendication 1, **caractérisé en ce qu'**une approximation de la valeur réelle (X) est déterminée en tant que paramètre de fonctionnement (P).

3. Procédé selon la revendication 2, **caractérisé en ce que** la première ou la deuxième valeur de mesure (m1, m2) est choisie comme approximation de la valeur réelle (X).

4. Procédé selon la revendication 2, **caractérisé en ce que** la sélection de la première ou de la deuxième valeur de mesure (m1, m2) s'effectue sur la base d'une classification des valeurs de mesure respectives.

5. Procédé selon la revendication 3 ou 4, **caractérisé en ce que** la sélection de la première ou de la deuxième valeur de mesure (m1, m2) s'effectue sur la base d'une précision attendue des valeurs de mesure respectives.

6. Procédé selon la revendication 2, **caractérisé en ce que** les première et deuxième valeurs de mesure (m1, m2) sont respectivement pourvues d'un facteur de pondération (f1, f2), et **en ce que** l'approximation de la valeur réelle (X) est déterminée comme paramètre de fonctionnement (P) à partir des première et deuxième valeurs de mesure (m1, m2) et du facteur de pondération respectivement associé (f2, f2).

7. Procédé selon la revendication 6, **caractérisé en ce que** le facteur de pondération (f1, f2) comprend un facteur de modèle qui est déterminé par le niveau d'un écart de la valeur de mesure associée (m1, m2) par rapport à un modèle de référence.

8. Procédé selon l'une quelconque des revendications 6 ou 7, **caractérisé en ce que** le facteur de pondération (f1, f2) comprend un facteur géométrique qui est déterminé par la position de la valeur de mesure respective (m1, m2) dans la section de mesure associée (21, 22).

9. Procédé selon l'une quelconque des revendications 6 à 8, **caractérisé en ce que** le facteur de pondération (f1, f2) comprend un facteur statistique qui est déterminé par une fonction de distribution statistique.

10. Procédé selon l'une quelconque des revendications 1 à 9, **caractérisé en ce que** l'apparition d'une perturbation et/ou d'un défaut et/ou d'une usure sur le moteur linéaire à stator long (2) est déterminée en tant que paramètre de fonctionnement (P).

11. Procédé selon l'une quelconque des revendications 1 à 10, **caractérisé en ce qu'**une position d'une unité de transport (1) sur la section de transport (20) est déterminée respectivement en tant que première et deuxième valeurs de mesure (m1, m2).

12. Procédé selon l'une quelconque des revendications 1 à 10, **caractérisé en ce qu'**une vitesse et/ou une accélération d'une unité de transport (1) sur la section de transport (20) sont déterminées en tant que première et deuxième valeurs de mesure (m1, m2).

13. Procédé selon l'une quelconque des revendications 1 à 10, **caractérisé en ce qu'**une température et/ou un courant sont déterminés respectivement en tant que première et deuxième valeurs de mesure (m1, m2).
